# NEUE EUROPÄISCHE PATENTSCHRIFT

(11) **EP 2 193 695 B2**
(45) Veröffentlichungstag und Bekanntmachung des Hinweises auf die Entscheidung über den Einspruch: **29.05.2019**
(45) Hinweis auf die Patenterteilung: 16.03.2011
(21) Anmeldenummer: 08834323.1
(22) Anmeldetag: 17.09.2008
(51) Int. Cl.: H05K 1/02

(54) **Elektronisches Bauteil mit einer Leiterplatte, Mauterfassungsgerät, Telematikgerät und System mit diesem Bauteil, und Verfahren zur Integration einer Kommunikationseinheit auf einer Leiterplatte**
Electronic component with a printed circuit, toll transponder, telematics device and system with such an electronic circuit, and method for integrating a communication unit on a printed circuit
Composant électronique avec un circuit imprimé, transpondeur à péage, dispositf de télématique et système munis d'un tel circuit, et procédé pour l'intégration d'une unité de communication sur un circuit imprimé

(30) Priorität: 20.09.2007 DE 102007045148
(43) Veröffentlichungstag der Anmeldung: 09.06.2010
(73) Patentinhaber: Continental Automotive GmbH, 30165 Hannover (DE)
(72) Erfinder: WANGLER, Josef, 78052 Villingen-Schwenningen (DE); HANKE, Klausdieter, 78050 Villingen-Schwenningen (DE); SCHRADI, Stefan, 78052 Villingen-Schwenningen (DE)
(86) Internationale Anmeldenummer: PCT/EP2008/062384
(87) Internationale Veröffentlichungsnummer: WO 2009/040283

(56) Entgegenhaltungen:
- EP-A1- 0 654 959
- DE-A1- 10 104 499
- DE-U1-202004 002 332
- GB-A- 2 394 365
- JP-A- S59 125 469
- JP-A- S59 175 747
- US-A- 6 052 765
- US-A1- 2007 013 572
- US-B2- 6 860 005
- US-B2- 7 243 851

## Beschreibung

Die Erfindung betrifft eine elektronische Schaltung mit einer Leiterplatte sowie ein Verfahren zur Integration einer Kommunikationseinheit auf einer Leiterplatte.

Im Bereich der Telematik, insbesondere der Verkehrstelematik, kommen heutzutage Mauterfassungsgeräte oder Telematikgeräte zum Einsatz. Diese Geräte weisen zumeist eine Recheneinheit zur Erzeugung von Daten auf, welche beispielsweise zur Berechnung von Straßennutzungsgebühren oder Verkehrsinformationen herangezogen werden. Zumeist weisen diese Geräte eine Leiterplatte auf, auf welcher eine Steuereinheit und eine Speichereinheit sowie eine Spannungsversorgung vorhanden ist. Oftmals erfolgt das Senden und Empfangen von externen Daten mittels einer Kommunikationseinheit, wie beispielsweise einem GSM-Modem oder einem DRSC-Modem. Bei der Verwendung derartiger Bauteile wird momentan im Wesentlichen auf zwei Lösungsansätze zurückgegriffen.

Zum einen können die Geräte eine erste Leiterplatte aufweisen, auf welcher die elektronischen Bauteile der telematischen Einheit des Mauterfassungsgeräts angeordnet sind, und eine weitere Leiterplatte, auf welcher das GSM-Modem angeordnet ist. Dabei ist die Leiterplatte mit den elektronischen Bauteilen der telematischen Einheit mit der Leiterplatte des GSM-Modems zumeist über Steckverbindungen verbunden, und die beiden Leiterplatten sind in einem gemeinsamen Gehäuse untergebracht. Der Vorteil einer solchen Lösung besteht darin, dass das GSM-Modem separat zugekauft werden kann. Nachteilig an einer derartigen Lösung ist, dass die Herstellung eines derartigen Mauterfassungs- oder Telematikgeräts einen großen Zeitaufwand erfordert und es insbesondere im Bereich der Verbindungen zu Fehlfunktionen kommen kann.

Die zweite Lösungsmöglichkeit besteht darin, sowohl die Bauteile der telematischen Einheit und die elektronischen Bauteile der Kommunikationseinheit mittels einer gemeinsamen Steuereinrichtung anzusteuern und auf einer Leiterplatte anzuordnen. Obwohl dabei sehr wenige Bauteile benutzt werden müssen, verändert sich insbesondere das Funkverhalten der GSM-Einheit im Vergleich zu eigenständigen GSM-Modulen. Das Austesten des Funkverhaltens erfordert jedoch langwierige Tests bezüglich des Funk- bzw. Hochfrequenzverhaltens der Kommunikationseinheit und führt auch zu einem erhöhten Ausschuss des elektronischen Bauteils, da bei einem Ausfall von verschiedenen Bauteilen nicht klar bestimmbar ist, welche Teile dem telematischen Teil des Bauteils zugehörig sind und welche Teile der Kommunikationseinheit zugeordnet sind.

Die DE 20 2004 002 332 U1 offenbart Leiterplatte mit einer Grundfläche, insbesondere einer rechteckigen Grundfläche, die in einem ersten Abschnitt mit elektrischen und/oder elektronischen Bauelementen bestückt ist und in einem zweiten an den ersten Abschnitt angrenzenden Abschnitt einen Kontaktierungsbereich zur Kontaktierung einer weiteren Leiterplatte aufweist.

Aufgabe der vorliegenden Erfindung ist es, ein elektronisches Bauteil mit einer Leiterplatte zu schaffen, welches die vorgenannten Nachteile überwindet und ein verbessertes Verhalten beim Testen des elektronischen Bauteils aufweist und somit das Qualitätsmanagement erleichtert. Des Weiteren soll es möglich sein, die Bauteile derart zu integrieren, dass eine Homologation der Kommunikationseinheit bereits vor dem Herstellen des elektronischen Bauteils möglich wird.

Die Aufgabe wird durch ein elektronisches Bauteil mit einer Leiterplatte gemäß Anspruch 1 und dem dazugehörigen Verfahren zur Integration einer Kommunikationseinheit auf einer Leiterplatte nach Anspruch 9 gelöst.

Die Erfindung ist eine elektrische Schaltung mit einer Leiterplatte, welche einen ersten und zweiten Bereich und eine Mehrzahl von auf der Leiterplatte angeordneten elektronischen Bauteilen aufweist, wobei der erste Bereich ausschließlich eine Kommunikationseinheit zum leitungsfreien, d. h. funkbasierten, Empfang und/oder leitungsfreien Senden von Informationen enthält und die im ersten Bereich angeordnete Kommunikationseinheit eine eigenständige, räumlich vom zweiten Bereich getrennte Anordnung von elektronischen Bauteilen mit einer eigenständigen Steuereinheit und Software ist und über eine Schnittstelle zur Kontaktierung mit elektronischen Bauteilen zum zweiten Bereich verfügt, wobei die Schnittstelle über Verbindungsleitungen mit dem zweiten Bereich verbunden ist und der zweite Bereich eine eigenständige telematische Steuereinheit aufweist.

Dadurch, dass der erste, vorzugsweise zusammenhängende Bereich ausschließlich die Kommunikationseinheit aufweist, wobei diese eine eigenständige Steuereinheit und Software aufweist, kann bereits vor Herstellung der gesamten Leiterplatte die Kommunikationseinheit selbständig getestet werden. Das in diesen Tests ermittelte oder vorab bekannte Hochfrequenzverhalten der Kommunikationseinheit bleibt aufgrund der räumlich getrennten Anordnung im ersten Bereich vollständig erhalten, so dass keine weiteren Tests bezüglich des Hochfrequenzverhaltens von Nöten sind und eine Homologation der Kommunikationseinheit eigenständig angestrebt werden kann.

Dadurch, dass der zweite Bereich der Leiterplatte über elektronische Bauteile der Telematikvorrichtung verfügt, werden die Entwicklungsprozesse der telematischen Einheit ohne Kommunikationseinheit und der Kommunikationseinheit voneinander entkoppelt und können einem getrennten Qualitätsmanagement unterworfen werden, was zu einer verbesserten Kommunikationsleistung führen kann. Dadurch, dass jedoch beide Bereiche auf einer Leiterplatte angeordnet sind, können elektronische Bauteile, wie insbesondere Stecker, eingespart werden, wobei auf der Leiterplatte wenige Verbindungsleitungen vorhanden sind, welche gleichzeitig die einzigen elektronisch leitenden Verbindungen zwischen dem ersten und zweiten Bereich darstellen. Über diese Leitungen können eine Stromversorgung, ein Datenaustausch zwischen der Kommunikationseinheit und dem telematischen Bereich im zweiten Bereich der Leiterplatte und auch logische Verbindungen zwischen den beiden realisiert werden.

Ein derartiges elektronisches Bauteil hat zudem den Vorteil, dass eine in einem getrennten Prozess entwickelte Kommunikationseinheit, bei welcher die Hochfrequenzeigenschaften bereits bekannt sind und eine Homologation bereits erfolgt ist, layout-, bauteil-, anordnungs- und softwareidentisch in den ersten Bereich der Leiterplatte übernommen werden kann und ausschließlich mittels auf der Leiterplatte aufgebrachter Verbindungsleitungen mit den elektronischen Bauteilen des zweiten Bereichs kommuniziert. Dies entspricht den externen Schnittstellen einer einständigen Kommunikationseinheit, wie beispielsweise eines GSM-Modems.

Weitere vorteilhafte Weiterbildungen der Erfindung sind in den untergeordneten Ansprüchen beschrieben.

Es ist insbesondere vorteilhaft, wenn die Kommunikationseinheit ein GSM-Modem und oder ein DRSC-Modem ist. Diese entsprechen den im Bereich der Verkehrstelematik häufigsten Kommunikationsprotokollen von Telematik- oder Mauterfassungsgeräten. Jedoch ist es auch möglich, UMTS- oder GPRS-Modems zu verwenden.

Zur verbesserten Sicherheit ist es vorteilhaft, wenn das GSM-Modem mit einer SIM-Karte verbindbar ist. Dadurch können externe Anbieter den Funkbetrieb des GSM-Modems eigenständig abwickeln, und die Zugangsdaten werden mit den gängigen Sicherheitsalgorithmen verschlüsselt.

Besonders vorzugsweise sind im zweiten Bereich der Leiterplatte zusätzlich zu einer Schnittstelle zum ersten Bereich eine Speichereinheit und/oder ein Datenspeicher und/oder eine Mensch-Maschine-Schnittstelle und/oder eine Kryptographieeinheit angeordnet. Dies entspricht im Wesentlichen denjenigen Bauteilen, welche zum Betrieb der Telematikeinheit ohne die Kommunikationseinheit notwendig sind. Weiterhin können ebenfalls ein GPS-Empfänger, ein Bluetooth-Modem ein W-LAN-Modem oder eine Maschine-Maschine-Schnittstelle, wie beispielsweise eine CAN-Schnittstelle, vorhanden sein. Für diese Module muss im Gegensatz zur vorgenannten Kommunikationseinheit keine eigenständige Homologation erworben werden.
Zur verbesserten Handhabung ist es sinnvoll, zwischen dem ersten und zweiten Bereich der Leiterplatte dort, wo nicht die Verbindungsleitungen verlaufen, z. B. Perforationen aufzubringen, um die räumliche Anordnung nach außen hin sichtbar zu machen. Dies hat den Vorteil, dass beim Qualitätsmanagement der zuständige Prüfer die gesamte Kommunikationseinheit sofort lokalisieren kann und sich nur mit den Bauteilen für diese auseinandersetzen muss. Gleiches gilt für einen Prüfer der telematischen Einheit. Vorteilhafterweise kommt ein elektronisches Bauteil in einem Mauterfassungsgerät oder einem Telematikgerät zum Einsatz.

Besonders bevorzugt wird ein elektronisches Bauteil gemäß der Erfindung eingesetzt, bei welchem die im ersten Bereich angeordnete Kommunikationseinheit layout-, bauteil-, anordnungs- und softwareidentisch mit einer bereits vorhandenen auf einer eigenständigen Leiterplatte angeordneten Kommunikationseinheit gleich ist. Auf diese Weise kann ein bereits bestehendes, bereits zugelassenes Kommunikationsmodul auf einer Leiterplatte kostengünstig und die Aufgaben hinsichtlich der Kommunikation im Layout technisch abbildend hergestellt werden.

Eine derartige Abbildung der Aufgaben innerhalb der Elektronik ist beispielsweise auch aus dem IT-Bereich bekannt, wo serviceorientierte Architekturen die technische Auslegung der IT-Architektur, die Aufgaben, widerspiegeln.

In dem bevorzugten Verfahren zur Integration einer Kommunikationseinheit zum leitungsfreien Empfang und/oder leitungsfreien Senden von Informationen auf einer Leiterplatte wird eine Leiterplatte zuerst in einen ersten und zweiten Bereich aufgeteilt. Daraufhin wird das Layout und die Anordnung einer bereits zugelassenen Kommunikationseinheit als auch eine Liste der elektronischen Bauteile der Kommunikationseinheit erstellt und das Layout auf den ersten Bereich der Leiterplatte übertragen. Eine in der bereits zugelassenen Kommunikationseinheit vorhandene Schnittstelle zu einer beispielsweise weiteren Leiterplatte mittels eines Steckers wird durch Verbindungsleitungen ersetzt, welche den ersten und zweiten Bereich der Leiterplatte miteinander verbinden. Dabei stellen die Verbindungsleitungen zwischen ersten und zweiten Bereich die einzige elektronische Verbindung zwischen beiden Bereichen dar.

Weitere vorteilhafte Ausbildungen des Verfahrens lassen sich den untergeordneten Ansprüchen entnehmen.

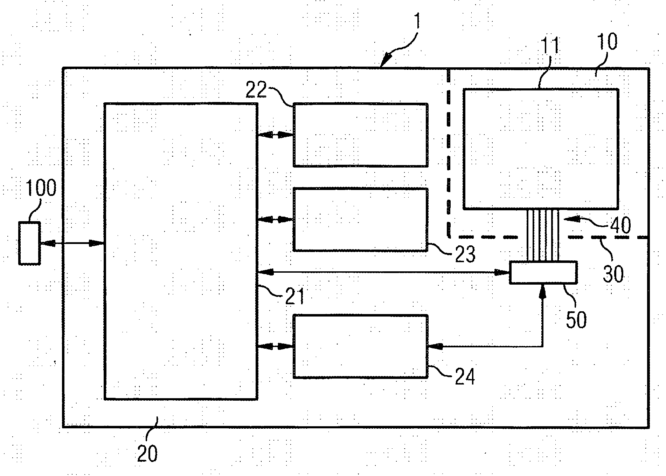

Im folgenden soll die Erfindung anhand Figur 1
genauer beschrieben werden.

Figur 1 zeigt eine Leiterplatte, welche in einem Mauterfassungs- oder Telematikgerät zum Einsatz kommt. Die einteilige Leiterplatte 1, welche beispielsweise in einem Mauterfassungsgerät angeordnet ist, weist einen ersten Bereich 10 und einen zweiten Bereich 20 auf, wobei der erste Bereich 10 und der zweite Bereich 20 voneinander räumlich getrennt sind. Dies wird durch die aufgebrachten Perforationen 30 zumindest optisch verstärkt.

Im ersten Bereich 10 der Leiterplatte ist ein GSM-Modem 11 angeordnet. Dieses weist eine eigenständige Steuereinheit und eine eigenständige Software auf und ist vorzugsweise ein Modem, welches als eigenständige Einheit bereits zugelassen oder homologiert ist. Die Homologation kann dabei in einem ersten Entwicklungsschritt bereits erfolgt sein. Das GSM-Modem 11 wird derart auf den ersten Bereich aufgebracht, dass das Layout und die Anordnung der elektronischen Bauteile derart gewählt ist, dass es mit einem bereits zugelassenen GSM-Modem identisch ist. Auch die Software des GSM-Modems 11 ist separat von einer etwaigen Software des zweiten Bereichs 20.

Im zweiten Bereich 20 befindet sich einen eigenständige telematische Steuereinheit 21, welche die telematischen Funktionen steuert. Diese ist dabei mit einem Speicher 22 verbunden, welcher als ROM- oder RAM-Speicher ausgeführt sein kann. Weiterhin ist ein GPS-Empfänger 23 vorhanden, welcher ebenfalls mit der telematischen Steuereinheit 21 kommuniziert. Zusätzlich zu dem GPS-Empfänger oder stattdessen können außerdem eine Kryptographieeinheit zum Verschlüsseln der Daten der telematischen Einheit unabhängig vom GSM-Modem 11 oder ein W-LAN-Modul oder Bluetooth-Modem zur Kommunikation mit beispielsweise externen Bluetooth- oder W-LAN-Geräten, wie Computern, Mobiltelefonen oder Personal-Digital-Assistants, vorgesehen sein. Des Weiteren weist der zweite Bereich 20 eine Spannungsversorgung 24 auf, welche sowohl die Steuereinheit 21 als auch den Speicher 22 und den GPS-Empfänger 23 bzw. weitere Bauteile mit Spannung versorgt.

Die zwischen dem ersten Bereich 10 und dem zweiten Bereich 20 angeordneten Perforationen 30 sind im Wesentlichen in einheitlichem kleinen Abstand voneinander angeordnet und weisen außer den durchführenden Verbindungsleitungen 40, welche als Leitungsbahnen ausgeführt sind, keine weiteren elektronischen oder elektrischen Verbindungen auf. Die Verbindungsleitungen 40 sind derart gestaltet, dass das GSM-Modem 11 über die virtuelle Schnittstelle 50, welche sich nicht zwangsläufig als Bauteil auf der Leiterplatte 1 befinden muss, durch die Spannungsvorrichtung 24 mit Spannung versorgt wird. Gleichzeitig findet über die Verbindungsleitungen 40 ein Datenaustausch zwischen der Steuereinheit 21 und der Steuereinheit des GSM-Modems 11 statt. Weiterhin ist die Leiterplatte 1 mit einer LAN-Schnittstelle ausgerüstet, welche mit einer externen Applikation, wie beispielsweise einem Fahrtenschreiber oder einer Bordelektronik 100, kommunizieren kann.

Das in der Figur 1 dargestellte GSM-Modem 11 weist zumindest eine Steuereinheit und eine Vorrichtung zum Empfangen und Senden auf. Die Steuereinheit und die Vorrichtung bestehen zumeist aus einer Vielzahl von elektronischen Bauteilen und Schaltelementen, welche hier nicht einzeln aufgeführt sind. Ein SIM-Kartenhalter muss beispielsweise nicht zwangsläufig im ersten Beriech 10 der Leiterplatte angeordnet sein, gleiches gilt für die Spannungsversorgung 24.

Um das GSM-Modem auf die Leiterplatte 1 zu integrieren, wird die Leiterplatte in den ersten Bereich 10 und zweiten Bereich 20 unterteilt. Dabei ist der erste Bereich 10 als zusammenhängender Bereich ausgebildet und durch die Perforationen 30 auch optisch gekennzeichnet.

Ein, in einem eigenständigen Verfahren entwickeltes und vorzugsweise bereits zugelassenes, externes GSM-Modem wird nun kopiert in dem Sinne, dass das Layout der elektronischen Bauteile, die Verbindung der elektronischen Bauteile untereinander und der Modelltyp der elektronischen Beuteile auf dem ersten Bereich 10 - baugleich zum externen GSM-Modem - aufgebracht und bilden auf der Leiterplatte 1 das GSM-Modem 11. Der einzige Unterschied zwischen dem externen GSM-Modem und dem GSM-Modem 11 besteht in der unterschiedlichen Ausführung der Verbindungsleitungen 40, welche auf der Leiterplatte 1, beispielsweise als Leitungsbahnen, ausgeführt werden können.

Um die elektronische Schaltung herzustellen, wird zunächst eine elektronische Bauteilanordnung mit einer bereits homologisierten bzw. zugelassenen Kommunikationseinheit ausgewählt. Die Bauteilanordnung wird hinsichtlich des Layouts und der verwendeten Bauteile nicht verändert.

Eine Datenverarbeitungsanlage, welche die Anordnung der elektronischen Bauteilanordnung in einem Speicher vorhält, ermittelt die Verbindung der elektronischen Bauteilanordnung zu weiteren elektronischen Komponenten und ändert gegebenenfalls das ursprüngliche Design der Verbindungen zu später auf einer Leiterplatte aufzubringenden Leiterbahnen um.

Anschließend erstellt die Datenverarbeitungsanlage den Anforderungen der elektronischen Schaltung mit der telematischen Steuereinheit entsprechend eine zweite elektronische Bauteilanordnung, welche eine Schnittstelle mit der elektronischen Bauteilanordnung wie obenstehend beschrieben aufweist. Es wird zunächst lediglich eine funktionelle Umsetzung der zweiten elektronischen Anordnung durchgeführt. Nachdem die zweite elektronische Bauteilanordnung hinsichtlich ihrer Funktionen ausgewählt wurde, wählt die Datenverarbeitungsanlage einen ersten abgeschlossenen und einen zweiten Bereich auf der einteiligen Leiterplatte aus, wobei der erste Bereich derart ausgewählt wird, dass die elektronische Bauteilanordnung mit der Kommunikationseinheit in ihrer Anordnung und mit den verwendeten Bauteilen ausschließlich auf diesem ersten Bereich Platz findet. Lediglich die als Leiterbahnen ausgebildete Verbindung wird in den Grenzbereich zwischen dem ersten und zweiten Bereich geführt. Um eine klarere optische Abgrenzung zwischen dem ersten und zweiten Bereich herzustellen, können auf der Leiterplatte Trennstellen im Grenzbereich vorgesehen werden.

Anschließend wird die zweite elektronische Bauteilanordnung im zweiten Bereich angeordnet, wobei die Anordnung im Sinne eines Layouts und die Bauteile derart ausgewählt werden, dass der im zweiten Bereich vorhandene Bauraum effizient genutzt wird, d. h. die Leiterplatte möglichst klein ausgebildet werden kann oder die zweite elektronische Bauteilanordnung im zweiten Bereich in funktionellen Gruppen angeordnet wird. Hierzu kann im zweiten Bereich auf bereits bekannte Verfahren zur automatisierten Layoutgenerierung zurückgegriffen werden.

Nachdem die Datenverarbeitungsanlage die zweite elektronische Bauteilanordnung an die Zwangsbedingung der festgelegten elektronischen Bauteilanordnung mit den Leiterbahnen im ersten Bereich adaptiert hat und die nunmehr aus der elektronischen Bauteilanordnung und der zweiten elektronischen Bauteilanordnung bestehende gesamte elektronische Schaltung als Layout auf einer Leiterplatte mit einem ersten und einem zweiten Bereich vorliegt, wobei die Leiterbahnen die einzige Verbindung zwischen der elektronischen Bauteilanordnung und der zweiten elektronischen Bauteilanordnung darstellen, werden das Layout und die verwendeten Bauteile in der Datenverarbeitungsanlage abgespeichert. Anschließend erstellt die Datenverarbeitungsanlage ein Verfahren zur Produktion einer derartigen elektronischen Schaltung.

Hierzu wird mindestens ein Roboter oder eine Robotergruppe angewiesen, die elektronische Schaltung wie im Speicher der Datenverarbeitungsanlage modellhaft vorgehalten zu fertigen. Hierbei können zeitgleich Bausteine in dem ersten und zweiten Bereich aufgebracht werden, da es lediglich darauf ankommt, dass das Layout und die Bauteilart der im ersten Bereich vorgehaltenen elektronischen Bauteilanordnung mit der Kommunikationseinheit mit einer bereits homologisierten Version übereinstimmen. Hierdurch bleibt die Homologation der Kommunikationseinheit im ersten Bereich bestehen, wohingegen Komponenten, welche diese Homologation aufheben könnten, ausnahmslos im zweiten Bereich angeordnet werden.

## Patentansprüche

1. Elektronische Schaltung mit einer einteiligen Leiterplatte (1), welche einen ersten Bereich (10) und einen zweiten Bereich (20) und eine Mehrzahl von auf der Leiterplatte angeordneten elektronischen Bauteilen (11, 21, 22, 23, 24) aufweist, wobei der erste Bereich (10) ausschließlich eine Kommunikationseinheit zum leitungsfreien Empfang und/oder leitungsfreien Senden von Informationen enthält und die im ersten Bereich angeordnete Kommunikationseinheit eine eigenständige, räumlich vom zweiten Bereich getrennte Anordnung von elektronischen Bauteilen mit einer eigenständigen Steuereinheit und Software ist und über eine Schnittstelle zur Kontaktierung mit elektronischen Bauteilen zum zweiten Bereich verfügt, wobei die Schnittstelle über Verbindungsleitungen (40) mit dem zweiten Bereich (20) verbunden ist und der zweite Bereich (20) eine eigenständige telematische Steuereinheit (21) aufweist.

2. Elektronische Schaltung nach Anspruch 1, **dadurch gekennzeichnet, dass** die Kommunikationseinheit ein GSM-Modem (11) und/oder ein DRSC-Modem ist.

3. Elektronische Schaltung nach Anspruch 2, **dadurchgekennzeichnet**, dass das GSM-Modem (11) mit einer SIM-Karte verbindbar ist.

4. Elektronische Schaltung nach einem der Ansprüche 1 bis 3, **dadurch gekennzeichnet, dass** auf dem zweiten Bereich (20) der Leiterplatte (1) ein Datenspeicher und/oder eine Mensch-Maschine-Schnittstelle und/oder eine Kryptographieeinheit sowie eine Schnittstelle (50) zum ersten Bereich angeordnet ist.

5. Elektronische Schaltung nach einem der vorhergehenden Ansprüche, **dadurch gekennzeichnet, dass** der erste und der zweite Bereich (10, 20) der Leiterplatte (1) mittels Trennstellen (30) voneinander beabstandet sind.

6. Mauterfassungsgerät mit einem elektronischen Bauteil nach einem der Ansprüche 1 bis 5.

7. Telematikgerät mit einem elektronischen Bauteil nach einem der Ansprüche 1 bis 5.

8. System, welches ein elektronisches Bauteil nach einem der Ansprüche 1 bis 5 und eine externe zugelassene Kommunikationseinheit umfasst, **dadurch gekennzeichnet, dass** das Layout und die Anordnung der elektronischen Bauteile, die elektronischen Bauteile und eine in mindestens einem der Bauteile vorgehaltenen Software des ersten Bereichs (10) der Leiterplatte (1) und der zugelassenen Kommunikationseinheit identisch sind.

9. Verfahren zur Integration einer Kommunikationseinheit zum leitungsfreien Empfang und/oder leitungsfreien Senden von Informationen auf einer einteiligen Leiterplatte (1), welches folgende Schritte aufweist:
a) Aufteilen einer einteiligen Leiterplatte in einen ersten und einen zweiten Bereich;
b) Erstellen einer Kopie einer elektronischen Bauteilanordnung einer zugelassenen Kommunikationseinheit mit einer Verbindungsschnittstelle zu weiteren Applikationen;
c) Aufbringen einer elektronischen Bauteilanordnung im ausschließlich ersten Bereich (10) der Leiterplatte (1), wobei die Bauteilanordnung und die Bauteilart mit der Kopie identisch ist, wobei als Verbindung mit elektronischen Komponenten im zweiten Bereich (20), Leiterbahnen auf die Leiterplatte (1) derart aufgebracht werden, dass diese Leiterbahnen die einzige elektronische Verbindung zwischen dem ersten Bereich und dem zweiten Bereich darstellen und ausschließlich die Verbindungsschnittstelle der zugelassenen Kommunikationseinheit bilden;
d) Aufbringen einer zweiten elektronischen Bauteilanordnung mit einer eigenständigen telematischen Steuereinheit (21) auf den zweiten Bereich der Leiterplatte (1).

10. Verfahren nach Anspruch 9, **dadurch gekennzeichnet, dass** die zugelassene Kommunikationseinheit ein GSM-Modem und/oder DSRC-Modem ist.

11. Verfahren nach einem der Ansprüche 9 oder 10, **dadurch gekennzeichnet, dass** auf dem zweiten Bereich (20) der Leiterplatte (1) ein Datenspeicher und/oder ein Mensch-Maschine-Schnittstelle und/oder eine Kryptographieeinheit sowie eine Schnittstelle (50) zum ersten Bereich aufgebracht werden.

12. Verfahren nach einem der Ansprüche 9 bis 11, **dadurch gekennzeichnet, dass** zwischen dem ersten und dem zweiten Bereich (10, 20) der Leiterplatte(1) Trennstellen (30) aufgebracht werden.

13. Verfahren nach einem der Ansprüche 9 bis 12, **dadurch gekennzeichnet, dass** eine Datenverarbeitungsanlage die Kopie der elektronischen Bauteilanordnung einer zugelassenen Kommunikationseinheit erstellt, die Leiterplatte in einen ersten und zweiten Bereich aufteilt und eine Anordnung der elektronischen Bauteilanordnung und die zugehörigen Leiterbahnen in dem ersten Bereich speichert.

14. Verfahren nach Anspruch 13, **dadurch gekennzeichnet, dass** die Datenverarbeitungsanlage zur Steuerung eines Roboters ausgebildet ist und den Roboter zur Herstellung der Leiterplatte mit der Kommunikationseinheit anweist.

## Claims

1. Electronic circuit with a one-piece printed circuit (1) which has a first area (10) and a second area (20) and a plurality of electronic components (11, 21, 22, 23, 24) arranged on the printed circuit, the first area (10) exclusively containing a communication unit for the wireless reception and/or wireless transmission of information and the communication unit arranged in the first area being an independent arrangement, spatially separate from the second area, of electronic components with an independent control unit and software and having an interface, for contacting electronic components, to the second area, the interface being connected to the second area (20) via connecting lines (40) and the second area (20) having an independent telematic control unit (21).

2. Electronic circuit according to Claim 1, **characterized in that** the communication unit is a GSM modem (11) and/or a DRSC modem.

3. Electronic circuit according to Claim 2, **characterized in that** the GSM modem (11) can be connected to a SIM card.

4. Electronic circuit according to one of Claims 1 to 3, **characterized in that** a data memory and/or a man-machine interface and/or a cryptography unit and an interface (50) to the first area is arranged on the second area (20) of the printed circuit (1).

5. Electronic circuit according to one of the preceding claims, **characterized in that** the first and the second area (10, 20) of the printed circuit (1) are spaced apart from one another by means of break points (30).

6. Toll transponder with an electronic component according to one of Claims 1 to 5.

7. Telematics device with an electronic component according to one of Claims 1 to 5.

8. System which comprises an electronic component according to one of Claims 1 to 5 and an external licensed communication unit, **characterized in that** the layout and the arrangement of the electronic components, the electronic components and software, held in at least one of the components, of the first area (10) of the printed circuit (1) and of the licensed communication unit are identical.

9. Method for integrating a communication unit for the wireless reception and/or wireless transmission of information on a one-piece printed circuit (1), which has the following steps:
a) Dividing a one-piece printed circuit into a first and a second area;
b) Generating a copy of an electronic component arrangement of a licensed communication unit with a connecting interface to other applications;
c) Applying an electronic component arrangement in the exclusively first area (10) of the printed circuit (1), the component arrangement and the type of component being identical with the copy, conductor tracks being applied to the printed circuit (1) as connection to electronic components in the second area (20), in such a manner that these conductor tracks represent the only electronic connection between the first area and the second area and exclusively form the connecting interface of the licensed communication unit;
d) Applying a second electronic component arrangement with an independent telematic control unit (21) to the second area of the printed circuit (1).

10. Method according to Claim 9, **characterized in that** the licensed communication unit is a GSM modem and/or DSRC modem.

11. Method according to one of Claims 9 or 10, **characterized in that** a data memory and/or a man-machine interface and/or a cryptography unit and an interface (50) to the first area are applied to the second area (20) of the printed circuit (1).

12. Method according to one of Claims 9 to 11, **characterized in that** break points (30) are applied between the first and the second area (10, 20) of the printed circuit (1).

13. Method according to one of Claims 9 to 12, **characterized in that** a data processing system creates the copy of the electronic component arrangement of a licensed communication unit, divides the printed circuit into a first and second area and stores an arrangement of the electronic component arrangement and the associated conductor tracks in the first area.

14. Method according to Claim 13, **characterized in that** the data processing system is constructed for controlling a robot and instructs the robot to produce the printed circuit with the communication unit.

## Revendications

1. Circuit électronique comprenant une carte de circuit imprimé monobloc (1) qui comporte une première zone (10) et une deuxième zone (20) et une pluralité de composants électroniques (11, 21, 22, 23, 24) disposés sur la carte de circuit imprimé, la première zone (10) ne contient qu'une seule unité de communication destinée à la réception sans fil et/ou l'émission sans fil d'informations et l'unité de communication disposée dans la première zone étant un ensemble de composants électroniques autonome qui est séparée spatialement de la deuxième zone et qui comporte une unité de commande et un logiciel autonome, et disposant d'une interface avec la deuxième zone destinée au contact avec des composants électroniques, l'interface étant connectée à la deuxième zone (20) par des lignes de connexion (40) et la deuxième zone (20) comportant une unité de commande télématique autonome (21).

2. Circuit électronique selon la revendication 1, **caractérisé en ce que** l'unité de communication est un modem GSM (11) et/ou un modem DRSC.

3. Circuit électronique selon la revendication 2, **caractérisé en ce que** le modem GSM (11) peut être relié à une carte SIM.

4. Circuit électronique selon l'une des revendications 1 à 3, **caractérisé en ce qu'**une mémoire de données et/ou une interface homme-machine et/ou une unité de cryptographie ainsi qu'une interface (50) avec la première zone est disposée sur la deuxième zone (20) de la carte de circuit imprimé (1).

5. Circuit électronique selon l'une des revendications précédentes, **caractérisé en ce que** les première et deuxième zones (10, 20) de la carte de circuit imprimé (1) sont espacées les unes des autres par des points de séparation (30).

6. Unité de détection de péage comportant un composant électronique selon l'une des revendications 1 à 5.

7. Unité télématique comportant un composant électronique selon l'une des revendications 1 à 5.

8. Système comprenant un composant électronique selon l'une des revendications 1 à 5 et une unité de communication autorisée externe, **caractérisé en ce que** la disposition et l'agencement des composants électroniques, les composants électroniques et un logiciel, fourni dans au moins un des composants, de la première zone (10) de la carte de circuit imprimé (1) et de l'unité de communication autorisée sont identiques.

9. Procédé d'intégration d'une unité de communication destiné à la réception sans fil et/ou l'émission sans fil d'informations sur une carte de circuit imprimé monobloc (1), lequel procédé comprend les étapes suivantes :
a) diviser une carte de circuit imprimé monobloc en une première et une deuxième zone ;
b) créer une copie d'un agencement de composants électroniques d'une unité de communication autorisée avec une interface de connexion à d'autres applications ;
c) disposer un agencement de composants électroniques dans la première zone exclusivement (10) de la carte de circuit imprimé (1), l'agencement de composants et le type de composant étant identiques à ceux de la copie, des pistes conductrices étant disposées comme connexion à des composants électroniques de la deuxième zone (20) sur la carte de circuit imprimé (1) de telle sorte que ces pistes conductrices représentent la seule connexion électronique entre la première zone et la deuxième zone et forment exclusivement l'interface de connexion de l'unité de communication autorisée ;
d) disposer un deuxième agencement de composants électroniques comportant une unité de commande télématique autonome (21) sur la deuxième zone de la carte de circuit imprimé (1).

10. Procédé selon la revendication 9, **caractérisé en ce que** l'unité de communication autorisée est un modem GSM et/ou un modem DSRC.

11. Procédé selon l'une des revendications 9 ou 10, **caractérisé en ce qu'**une mémoire de données et/ou une interface homme-machine et/ou une unité de cryptographie ainsi qu'une interface (50) avec la première zone sont disposées sur la deuxième zone (20) de la carte de circuit imprimé (1).

12. Procédé selon l'une des revendications 9 à 11, **caractérisé en ce que** des points de séparation (30) sont disposés entre les première et deuxième zones (10, 20) de la carte à circuit imprimé (1).

13. Procédé selon l'une des revendications 9 à 12, **caractérisé en ce qu'**un système de traitement de données crée la copie de l'agencement de composants électroniques d'une unité de communication autorisée, divise la carte de circuit imprimé en une première zone et une deuxième zone et mémorise un agencement de l'agencement de composants électroniques et des pistes conductrices associées dans la première zone.

14. Procédé selon la revendication 13, **caractérisé en ce que** le système de traitement de données est conçu pour commander un robot et ordonne au robot de produire la carte de circuit imprimé avec l'unité de communication.
